# EUROPEAN PATENT APPLICATION

(11) **EP 2 549 533 A1**
(43) Date of publication of application: **23.01.2013**
(21) Application number: 12176905.3
(22) Date of filing: 18.07.2012
(51) Int. Cl.: H01L 25/065, H01L 25/10

(54) **Double-sided flip chip package**

(30) Priority: 21.07.2011 US 201113188287
(71) Applicant: Apple Inc., Cupertino, CA 95014 (US)
(72) Inventor: Zhai, Jun, Cupertino, CA 95014 (US); Von Kaenel, Vincent R., Cupertino, CA 95014 (US)
(74) Representative: Lang, Johannes

(57) **Abstract**

Semiconductor device modules having two or more integrated circuit dies mounted on opposing sides of a substrate. The integrated circuit dies are mounted by use of surface mount connections, such as flip chip connections implemented using conductive bumps. Systems may include one or more of the present semiconductor device modules, and in some cases may also include other modules, such as a system module.

## Description

### BACKGROUND

### Technical Field

This disclosure relates generally semiconductor devices, and more particularly to multi-die modules.

### Description of the Related Art

Capacity of device packages such as, for example, DDR memory packages, may be improved by increasing the quantity of integrated circuit dies per package. For example, one or more pairs of stacked dies may be implemented within a memory packages to increase the memory capacity as compared to memory packages having unstacked dies, without significantly increasing the footprint of the package. Such stacked memory packages typically employ wire bonding for connecting dies to a module substrate.

Flip chip connection of integrated circuit (IC) devices may provide desirable inductance characteristics (e.g., lower signal and/or power inductance). Also, connection density may be much greater than that which is possible with wire bonded integrated circuit devices. Flip chip connections may use conductive bumps disposed on one surface of a die to facilitate connection to a substrate. Thus, flip chip connections may not be well suited for typical stacked die configurations.

### SUMMARY

Various structures and techniques providing semiconductor device packages having two or more integrated circuit dies mounted on opposing sides of a substrate are disclosed. These integrated circuit dies are mounted by use of surface mount connections, such as flip chip connections implemented using conductive bumps. In certain embodiments, the disclosed structures and techniques may facilitate higher device density within a package, while providing reduced inductance values and improved connector density.

One embodiment of an electronic device module may include a first die electrically connected to a first surface of a module substrate via a flip chip connection, and a second die electrically connected to a second, substantially opposite surface of the module substrate, also via a flip chip connection. Particular embodiments may further include conductors on the first side of the module substrate to facilitate connection of the electronic device module to external components. Other embodiments may include conductors disposed on one or more surfaces of the module substrate other than the first surface for external connection. Some embodiments may be configured for external connection via conductors disposed at more than one surface of the module substrate. For example, one such embodiment may be a memory module including two or more DDR dies flip chip mounted on opposite surfaces of a module substrate, where the memory module is configured for connection to a system module that includes a system-on-a-chip (SOC). The particular memory module may in some cases be further configured for connection to a third module, such as an another memory module, thereby facilitating a system that in includes the SOC and the two memory modules.

In particular embodiments, an electronic device module may include a first integrated circuit electrically connected to a first set of conductors of a module substrate, and a second integrated circuit electrically connected to a second set of conductors of the module substrate. The first and second set of conductors may be disposed on substantially opposite surfaces of the module substrate, and may be electrically connected to the first and second integrated circuits using conductive bumps, such as solder bumps. Some embodiments may include additional integrated circuits electrically connected to the module substrate. In some embodiments, the module substrate further includes one or more sets of electrical conductors that are configured for external connection (e.g., for connection to SOC modules, memory modules, or other modules). The one or more sets of electrical conductors may in some cases be configured for connection using one or more ball grid arrays.

In some embodiments of the present disclosure, a system may include a first module electrically connected to a second module. The modules may be connected via a set of electrical conductors disposed at a first module substrate. In addition to the first module substrate, the first module may include a first die and a second die. The first and second die may respectively be electrically connected to opposite surfaces of the first module substrate via flip chip connections. In some embodiments, the second module may include a SOC. The first module may be a memory module in various embodiments.

### BRIEF DESCRIPTION OF THE DRAWINGS

The following detailed description makes reference to the accompanying drawings, which are now briefly described.

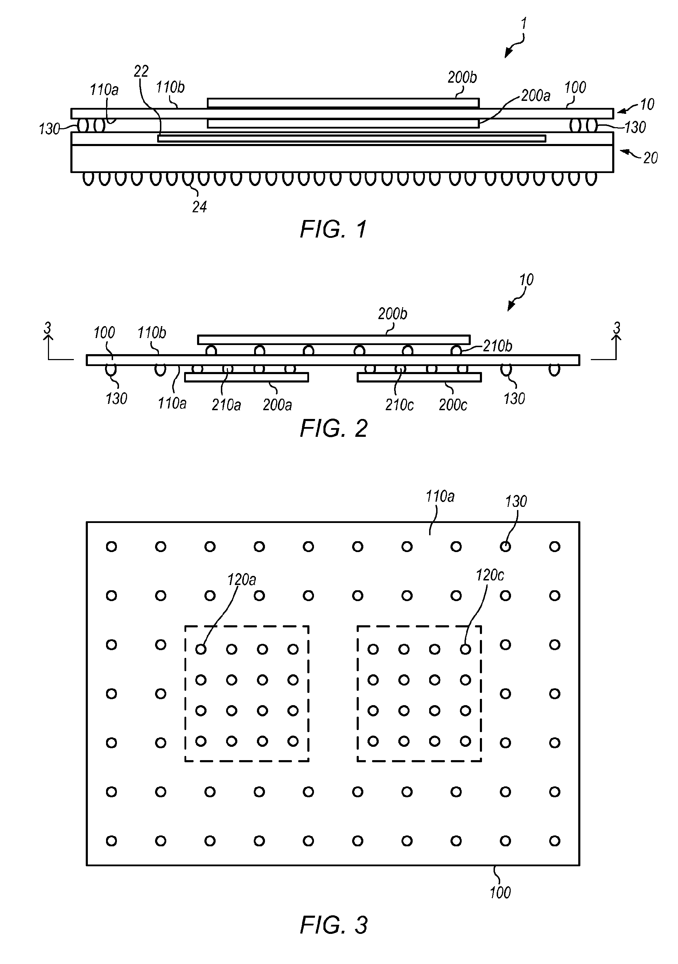

FIG. 1 depicts a system in accordance with one embodiment of the present disclosure. The depicted system includes a first module having two integrated circuits oppositely mounted to a module substrate, and a second module coupled to the first module.

FIG. 2 depicts a module including three dies mounted to a module substrate. The three mounted dies include two dies mounted using conductive bumps to a first side of the module substrate, and a third die mounted to a second side of the module substrate using conductive bumps. The module substrate also includes conductors for providing an electrical connection to components external to the module.

FIG. 3 is a bottom view of various components of the embodiment depicted in FIG. 2, as viewed from line 3-3 of FIG. 2. Electrical conductors disposed at a surface of the module substrate are depicted. The electrical conductors include a set of conductors for connection to components external to the module, a set of conductors for connection to a first die, and a set of conductors for connection to a second die.

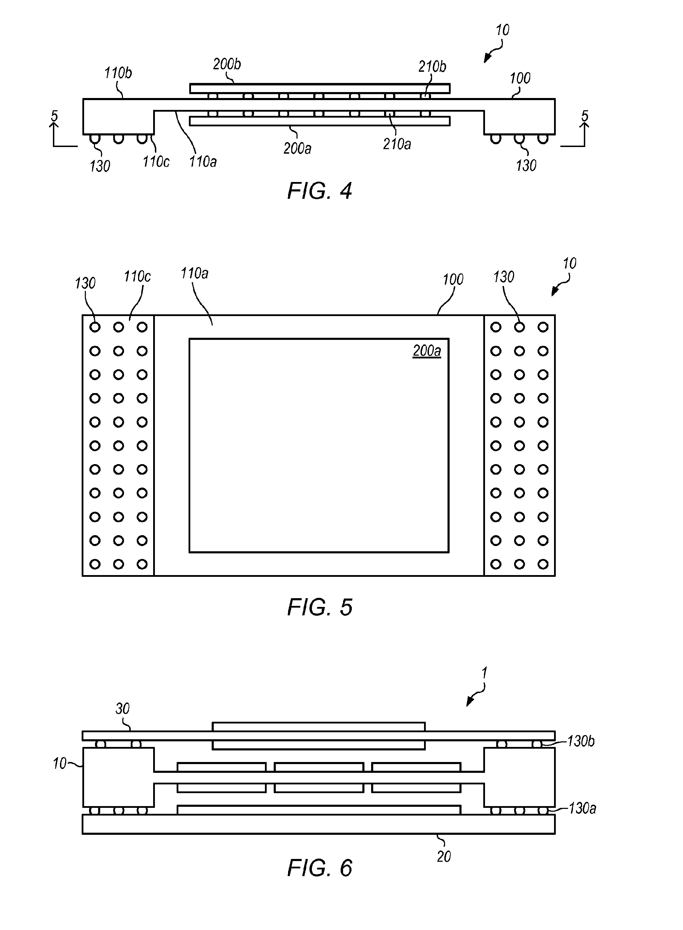

FIG. 4 depicts a module including two integrated circuits mounted to a module substrate. The two integrated circuits include an IC mounted using conductive bumps to a first side of the module substrate, and a second IC mounted to a second side of the module substrate using conductive bumps. The module substrate also includes conductors, located on surfaces that are offset from and parallel to the first side of the module substrate, for providing an electrical connection to components external to the module.

FIG. 5 is a bottom view of the embodiment depicted in FIG. 4, as viewed from line 5-5 of FIG. 4. Electrical conductors for connection to external components are depicted as being disposed at surfaces of the module substrate that are offset with respect to the surface at which the depicted IC is mounted. The electrical conductors include a set of conductors for connection to components external to the module, a set of conductors for connection to a first die, and a set of conductors for connection to a second die.

FIG. 5 is a bottom view of the embodiment depicted in FIG. 4, as viewed from line 5-5 of FIG. 4. A set of electrical conductors for connection to external components are depicted as being disposed at surfaces of the module substrate that are offset with respect to the surface at which the depicted IC is mounted. The module also includes a set of conductors for connection to a first die, and a set of conductors for connection to a second die.

FIG. 6 depicts a system in accordance with an embodiment of the present disclosure having three modules. The depicted system includes a first module having six dies, with three dies mounted at each of two opposing sides of a module substrate. A second module having one die is depicted as being coupled to the first module. The first module is also coupled to a third module that includes two dies mounted to opposing sides of the substrate of the third module. The first module includes offset surfaces that serve as stand offs for facilitating connection to the second and third modules. Ball grid array connections are used in the connections between the first module and the second and third modules in the depicted embodiment.

Specific embodiments are shown by way of example in the drawings and will be described herein in detail. It should be understood, however, that the drawings and detailed description are not intended to limit the claims to the particular embodiments disclosed, even where only a single embodiment is described with respect to a particular feature. On the contrary, the intention is to cover all modifications, equivalents and alternatives that would be apparent to a person skilled in the art having the benefit of this disclosure. Examples of features provided in the disclosure are intended to be illustrative rather than restrictive unless stated otherwise.

The headings used herein are for organizational purposes only and are not meant to be used to limit the scope of the description. As used throughout this application, the word "may" is used in a permissive sense (i.e., meaning having the potential to), rather than the mandatory sense (i.e., meaning must). The words "include," "including," and "includes" indicate open-ended relationships and therefore mean including, but not limited to. Similarly, the words "have," "having," and "has" also indicated open-ended relationships, and thus mean having, but not limited to. The terms "first," "second," "third," and so forth as used herein are used as labels for nouns that they precede, and do not imply any type of ordering (e.g., spatial, temporal, logical, etc.) unless such an ordering is otherwise explicitly indicated. For example, a "third die electrically connected to the module substrate" does not preclude scenarios in which a "fourth die electrically connected to the module substrate" is connected prior to the third die, unless otherwise specified. Similarly, a "second" feature does not require that a "first" feature be implemented prior to the "second" feature, unless otherwise specified.

Various components may be described as "configured to" perform a task or tasks. In such contexts, "configured to" is a broad recitation generally meaning "having structure that" performs the task or tasks during operation. As such, the component can be configured to perform the task even when the component is not currently performing that task (e.g., a set of electrical conductors may be configured to electrically connect a module to another module, even when the two modules are not connected). In some contexts, "configured to" may be a broad recitation of structure generally meaning "having circuitry that" performs the task or tasks during operation. As such, the component can be configured to perform the task even when the component is not currently on. In general, the circuitry that forms the structure corresponding to "configured to" may include hardware circuits.

Various components may be described as performing a task or tasks, for convenience in the description. Such descriptions should be interpreted as including the phrase "configured to." Reciting a component that is configured to perform one or more tasks is expressly intended not to invoke 35 U.S.C. § 112, paragraph six, interpretation for that component.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of this application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

### DETAILED DESCRIPTION OF EMBODIMENTS

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Turning to FIG. 1, an illustration of an embodiment of system 1 is shown. As depicted, multi-module system 1 includes electronic device module 10 electrically coupled to module 20 via connections using module conductors 130. As one example, module 20 may be a system module that includes integrated circuit die 22 (e.g., a processor), and electronic device module 10 may be a module (e.g., a memory module) having multiple integrated circuit dies 200 (e.g., memory ICs). In some embodiments, module 20 may include integrated circuit die 22 that is a system-on-a-chip. Various embodiments may include electronic device module 10 and/or module 20 providing other functionality such as, for example, graphics control, digital signal processing, and communication protocol functions.

Electronic device module 10 may provide configurability to system 1. For example, consider a prior system in which a processor and memory are disposed in a common package, on a common substrate. In such as system, inventory of common packages that include fixed configurations of processor and memory may be required to satisfy product demand within an acceptable lead time. Many fixed configuration representing the various combinations of processor and memory may be required. The stored inventory of fixed configurations may represent an inventory risk due to possible component price changes, component product evolution, and component obsolescence. For example, stored common packages including a particular memory integrated circuit may become undesirable due to the release of better performing memory, or a change in price.

A present exemplary system using a memory module and a processor module may reduce inventory risk by enabling storage of reduced inventory resulting from shorter lead time associated with assembly of a system from the various modules. Furthermore, as components of specific modules become obsolete, other modules of the present exemplary system are not affected. For example, an obsolescence of a particular memory product causes the obsolescence of only corresponding memory modules, and not of processor modules or other memory modules.

In contrast, inventory of the above-discussed prior common package may become obsolete due to obsolete memory being integrated into the common package. Because the processor is also integrated to the common package, the possible obsolescence of memory also causes inventory risk related the integrated processors.

Furthermore, the modules of the present embodiments may provide preferable units for testing and procurement. For example, a memory module in accordance with the present disclosure that is provided by a memory supplier presents an opportunity for that memory supplier to conduct quality assurance at the module level, instead of only at the die level. Accordingly, efficiencies can be gained through the higher-level testing performed by the supplier prior to delivery to the customer. Therefore, various risks associated with defect creation during assembly may be shifted to the module supplier.

Electrical connection between electronic device module 10 and module 20 via module conductors 130 may be accomplished using various interconnect formats. For example, embodiments of system 1 may include electronic device module 10 and module 20 electrically coupled using ball grid array, pin grid array, land grid array, dual in-line package, or other suitable interconnect form factors. In some cases, embodiments of system 1 may include multiple module conductors 130 employing multiple, differing interconnect formats. Module conductors 130 may be arranged symmetrically with respect to surface 110 of module substrate 100 (see FIG. 3), or may in some cases be arranged asymmetrically with respect to surface 110. System conductors 24 may facilitate connection of system 1 to external components, such as a system board. System conductors 24 may in some embodiments include the same interconnect formats used in module conductors 130. In other embodiments, system conductors 24 may employ interconnect formats that are different (or additional) to the interconnect formats used in module conductors 130.

Turning to FIG. 2, the depicted embodiment of electronic device module 10 includes three integrated circuit dies 200 mounted to module substrate 100 using conductive bumps 210. Integrated circuit die 200a and integrated circuit die 200c are electrically connected at surface 110a of module substrate 100 using conductive bumps 210a and conductive bumps 210b. Integrated circuit die 200b is electrically connected using conductive bumps 210b at surface 110b, which is opposite to surface 110a on module substrate 100. Disposed on surface 110a are module conductors 130, which are configured to provide electrical coupling to an external component, such as module 20.

Conductive bumps 210 may include solder bumps providing electrical connection between integrated circuit dies 200 and module substrate 100 by way of a flip chip connection formed using, for example, ultrasonic of reflow solder processes. In some embodiments, a flip chip connection may be formed using other bumps (e.g., gold stud bumps) and other processes (e.g., conductive film or tape).

Use of flip chip connections provides several advantages over alternative connection methods. For example, flip chip connections may be much shorter than wire bonded connections. Accordingly, designs providing lower inductance values (e.g., power inductance and signal inductance) may be achieved. Furthermore, the availability of an entire side of a die for placement of conductive bumps in a flip chip implementation provides an opportunity for higher conductor density (e.g., a larger number of input/output signals and power/ground signals) than is typically possible with wire bonding.

The mounting of integrated circuit dies 200 on opposing sides of module substrate 100 may allow increased density of integrated circuit dies 200 within a particular footprint for electronic device module 10 and system 1. The dense configuration that may be facilitated by such double-sided mounting of integrated circuit dies 200 may accommodate compact design constraints imposed in form factor-sensitive implementations, such as mobile devices. Various integrated circuit dies 200 mounting configurations may be used in specific embodiments of electronic device module 10, including symmetric or asymmetric configurations of varying quantities of dies. For example, FIGS. 1, 4, and 6 each depict a module having one die mounted on each of two opposing surfaces of a module substrate. *See* FIG. 1, element 10; FIG. 4, element 10; FIG. 6, element 30. FIG. 2 depicts an embodiment in which one die is mounted on a first surface of a module substrate, and two dies are mounted on the opposing surface. Element 10 of FIG. 6 includes three dies mounted on each of two opposing sides of a module substrate.

In some embodiments, electronic device module 10 may include multiple identical integrated circuit dies 200 mounted on module substrate 100. One such embodiment is a memory module in which identical memory integrated circuits may be used to provide storage for use by a system-on-a-chip. Other embodiments of electronic device module 10 may include a variety of integrated circuit dies 200 mounted on module substrate 100. For example, a particular memory module may be configured to a provide separate system memory and graphics memory to a coupled system. In this particular exemplary memory module, the system memory may be provided using one or more of a particular integrated circuit, and the graphics memory may be provided using one or more a different integrated circuit. Other embodiments of electronic device module 10 may include integrated circuit dies 200 that provide functionality other than memory, such as, for example, graphics control, digital signal processing, and communication protocol functions.

FIG. 3 depicts surface 110a of module substrate 100, as viewed from line 3-3 of FIG. 2. Electrical conductors disposed at a surface of the module substrate are shown. The electrical conductors include substrate conductors 120a, which correspond to conductive bumps 210a that are used for electrically connecting to integrated circuit die 200a. Similarly, substrate conductors 120b correspond to conductive bumps 210b that are used for electrically connecting to integrated circuit die 200b. Although substrate conductors 120a and substrate conductors 120b are similar arrays in the embodiment depicted in FIG. 3, other embodiments may include substrate conductors 120 having patterns different than those depicted, and/or different from each other. Dashed lines denote the outlines of integrated circuit die 200a and integrated circuit die 200b profiles when mounted to module substrate 100. Mounting of integrated circuit dies 200 may include underfilling using an insulator.

Turning now to FIGS. 4 and 5, an alternate embodiment of electronic device module 10 is depicted. In contrast to the embodiment shown in FIGS. 2 and 3 that includes module conductors 130 disposed at surface 110 of module substrate 100, the embodiment of FIGS. 4 and 5 includes module conductors 130 disposed at surface 110c. Surface 110c may be offset from surface 110a, and thus provide additional clearance between integrated circuit die 200a and a component to which electronic device module 10 is connected. For example, a configuration of module substrate 100 may include standoffs to accommodate clearance between integrated circuit die 200a and components of a system board or module to which electronic device module 10 may be connected. The embodiment of FIG. 3 includes module conductors 130 arranged symmetrically along the periphery of surface 110, and the embodiment of FIG. 5 includes module conductors 130 arranged symmetrically near two edges of module substrate 100. Other embodiments may include module conductors 130 arranged in other configurations, including asymmetric configurations. Embodiments may also include module conductors 130 of various form factors, such as ball grid array, pin grid array, land grid array, dual in-line package, or other suitable interconnect form factors.

FIG. 6 depicts an embodiment of system 1 that includes electronic device module 10 electrically coupled via module conductors 130a to module 20, and via module conductors 130b to device module 30. Electronic device module 10 includes a module substrate configured such that clearance is provided between the integrated circuits mounted on electronic device module 10 and the integrated circuits mounted on module 20 and device module 30. In some embodiments, module 20 may include a system-on-a-chip package, with electronic device module 10 and module 20 being memory packages serially stacked upon the system package. In other embodiments, electronic device module 10 may be a system package, with module 20 and device module 30 being memory packages stacked on either side of system package. Some embodiments may include additional packages stacked above device module 30 and/or below module 20. Particular embodiments may include packages having integrated circuits that perform different or additional functions, including for example control, signal processing, and power-related functions.

Although the embodiments above have been described in considerable detail, numerous variations and modifications will become apparent to those skilled in the art once the above disclosure is fully appreciated. It is intended that the following claims be interpreted to embrace all such variations and modifications.

## Claims

1. An electronic device module, comprising:
a module substrate including a first surface, a second surface substantially opposite of the first surface, and a first set of electrical conductors configured to electrically connect the electronic device module;
a first die electrically connected to the module substrate via a flip chip connection with the first surface of the module substrate; and
a second die electrically connected to the module substrate via a flip chip connection with the second surface of the module substrate.

2. The electronic device module of claim 1, wherein the first set of electrical conductors is configured to electrically connect the electronic device module to a module comprising a system on a chip.

3. The electronic device module of claim 2, further comprising:
a second set of electrical conductors configured to electrically connect the electronic device module to another module, wherein the second set of electrical conductors is configured to electrically connect the electronic device module from a direction substantially opposite from the direction the module comprising the system on a chip is connected.

4. The electronic device module of any preceding claim, wherein the first set of electrical conductors are disposed on the first surface of the module substrate, and wherein the first set of conductors are configured to electrically connect the electronic devise using a ball grid array.

5. The electronic device module of any of claims 1, 2, and 3, wherein the first set of electrical conductors is disposed at least in part on a third surface of the module substrate, the third surface being different from the first surface and being substantially parallel to the first surface.

6. The electronic device module of any preceding claim, wherein:
the module substrate further comprises a third set of electrical conductors; and
wherein the electronic device module is configured to be electrically connected via the third set of electrical conductors.

7. The electronic device module of claim 6, wherein the third set of electrical conductors is configured to electrically connect the electronic device module to a module comprising a system on a chip.

8. The electronic device module of any of claims 6 and 7, wherein the third set of electrical conductors is disposed at the first surface of the module substrate.

9. The electronic device module of any of claims 6, 7, and 8, wherein the third set of electrical conductors is disposed at least in part on a third surface of the module substrate, the third surface being different from first surface and being substantially parallel to the first surface.

10. The electronic device module of any preceding claim, wherein the first die comprises memory.

11. A system, comprising:
a first module comprising:
a first module substrate including a first surface, a second surface substantially opposite of the first surface, and a first set of electrical conductors;
a first die electrically connected to the first module substrate via a flip chip connection with the first surface of the first module substrate; and
a second die electrically connected to the first module substrate via a flip chip connection with the second surface of the first module substrate; and a second module electrically connected to the first module via the first set of electrical conductors of the first module substrate, the second module comprising a second module substrate.

12. The system of claim 11, wherein the second module is a system in a package.

13. The system of any of claims 11 and 12, wherein the second module is electrically connected to the first module using a ball grid array.

14. The system of any of claims 11, 12, and 13, further comprising:
a third module electrically connected to the first module via a second set of electrical conductors disposed on the first module substrate.

15. The system of claim 14, wherein the third module is electrically connected to the first module using a ball grid array.
